(19)

Europäisches
Patentamt

European
Patent Office

Office européen
des brevets

(11) **EP 4 637 036 A1**

(12) **EUROPEAN PATENT APPLICATION**

(43) Date of publication:
**22.10.2025 Bulletin 2025/43**

(21) Application number: **24171246.2**

(22) Date of filing: **19.04.2024**

(51) International Patent Classification (IPC):
$H03M\ 1/10^{(2006.01)}$    $H03M\ 3/00^{(2006.01)}$
$H03M\ 1/14^{(2006.01)}$    $H03M\ 1/38^{(2006.01)}$

(52) Cooperative Patent Classification (CPC):
**H03M 1/1033; H03M 3/386;** H03M 1/14; H03M 1/38

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **GAO, Yihan**
  **5656 AG Eindhoven (NL)**
• **LIU, Qilong**
  **5656 AG Eindhoven (NL)**
• **RUTTEN, Robert**
  **5656 AG Eindhoven (NL)**
• **BAJORIA, Shagun**
  **5656 AE Eindhoven (NL)**
• **BOLATKALE, Muhammed**
  **5656 AE Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

Remarks:
Amended claims in accordance with Rule 137(2) EPC.

(54) **ADC ERROR CORRECTION**

(57) A calibration circuit (700) for correcting timing errors introduced by a DAC (104) in a signal path of an ADC (101), the calibration circuit (700) comprising: an input subtraction module (701) configured to subtract an estimated error from an output of the ADC (101) and provide a corrected output; a filter module (704) configured to approximate an error transfer function corresponding to the DAC timing errors; a correlation module (705) configured to correlate the corrected output with an output from the filter module (704) to extract an error term ($e_i$); an integrator module (708) configured to integrate the error term ($e_i$) to provide an updated error coefficient ($k_i$); and a correction module (709) configured to correlate the updated error coefficient ($k_i$) with the output from the filter module (704) to provide the estimated error to the input subtraction module (701).

$$Y = \frac{1}{N}\sum D_i$$

|ΔD$_i$| ➜ ISI calibration (NRZ)
ΔD$_i$ ➜ timing mismatch calibration (NRZ)
D$_i$ ➜ timing mismatch calibration (RZ, DRZ)

Fig. 7

EP 4 637 036 A1

**Description**

Field

The disclosure relates to calibrating and correcting for errors in an output of an analog to digital converter (ADC).

Background

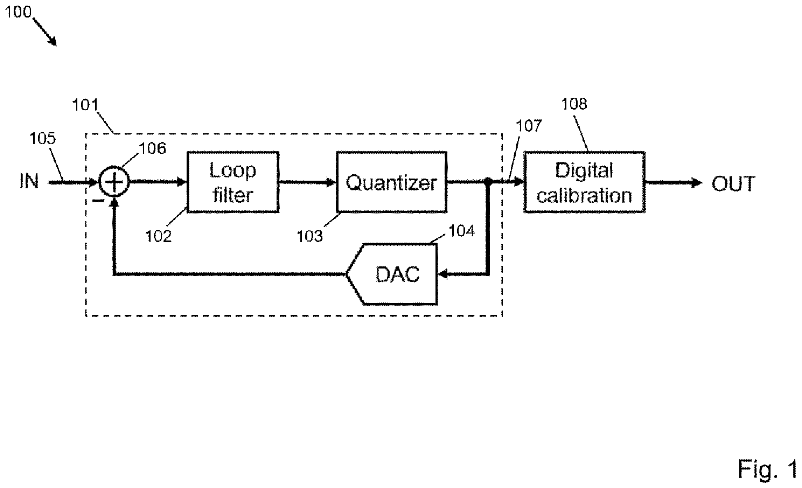

Many signal processing applications involve conversion of received analog signals into digital signals for processing. Converting and otherwise processing the signals accurately can be challenging, particularly for high frequency signals. Figure 1 illustrates an example architecture of a particular type of ADC circuit comprising a delta-sigma modulator (DSM) ADC 101. The DSM 101 comprises a loop filter 102, a quantizer 103 and a digital to analog converter (DAC) 104. An input signal is provided at an input 105 of the DSM 101. The input signal is combined with a feedback signal from the DAC 104 at an input summing module 106, the output of which is provided to the loop filter 102. The quantizer 103 receives an output from the loop filter 102 and provides an output 107 of the DSM 101. In a DSM, the quantization error at the output 107 is shaped by the loop transfer function. However, any error produced by the DAC 104 will be injected at the input summing module 106 and will tend to limit the noise and distortion performance of the DSM 101. To improve performance of the ADC circuit 100, a digital calibration module 108 may be connected to the output 107 of the DSM 101. The digital calibration module 108 may for example be configured to calibrate for static mismatch arising from the DAC 104 in the digital domain, for example as disclosed in US10541699B1. However, the methods disclosed in US10541699B1 do not correct for DAC-introduced timing errors including inter-symbol interference (ISI) and timing mismatches, which become more dominant as the sampling frequency of the DAC increases.

Summary

According to a first aspect there is provided a calibration circuit for correcting timing errors introduced by a DAC in a signal path of an ADC, the calibration circuit comprising:

an input subtraction module configured to subtract an estimated error from an output of the ADC and provide a corrected output;
a filter module configured to approximate an error transfer function corresponding to the DAC timing errors;
a correlation module configured to correlate the corrected output with an output from the filter module to extract an error term;
an integrator module configured to integrate the error term to provide an updated error coefficient; and
a correction module configured to multiply the updated error coefficient with the output from the filter module to provide the estimated error to the input subtraction module.

The digital calibration scheme disclosed herein is capable of estimating and correcting for DAC timing errors with different coding schemes to achieve high linearity.
The filter module of the calibration circuit may be a digital filter, for example a finite impulse response, FIR, filter, an infinite impulse response, IIR, filter or a combination.
The error transfer function may correspond to a coding scheme of the ADC, the coding scheme being one of a return to zero scheme, a non-return to zero scheme, and a dual return to zero scheme.
The filter module may comprise a plurality of taps with corresponding tap coefficients corresponding to the coding scheme of the ADC.
The DAC timing errors may include inter-symbol interference, ISI, and timing mismatch errors.
The calibration circuit may comprise a multiplier between the correlation module and integrator module, the integrator module and multiplier configured to provide the updated error coefficient by integration of the error term with an adjustable loop gain.
According to a second aspect there is provided an ADC circuit comprising:

an ADC having an input for receiving an analog input signal, an output for providing a digital signal and a signal path between the input and output comprising a DAC; and
a calibration circuit according to the first aspect connected to the output of the ADC.

The ADC may be selected from one of:

a continuous time delta-sigma modulator;

a continuous time pipeline ADC; and
a continuous time zoom ADC.

The DAC may be a single-bit or multi-bit DAC having N elements, the ADC circuit having N calibration circuits corresponding to each of the N elements of the DAC.

According to a third aspect there is provided a method of correcting timing errors introduced by a DAC in a signal path of an ADC with a calibration circuit, the method comprising:

subtracting with an input subtraction module an estimated error from an output of the ADC and providing a corrected output;

approximating with a filter module an error transfer function corresponding to the DAC timing errors;

correlating with a correlation module the corrected output with an output from the filter module to extract an error term;

integrating with an integrator module the error term to provide an updated error coefficient; and

multiplying with a correction module the updated error coefficient with the output from the filter module to provide the estimated error to the input subtraction module.

The filter module of the calibration circuit may be a digital filter, for example a finite impulse response, FIR, filter, an infinite impulse response, IIR, filter, or a combination.

The error transfer function may correspond to a coding scheme of the ADC, the coding scheme being one of a return to zero scheme, a non-return to zero scheme, and a dual return to zero scheme.

The filter module may comprise a plurality of taps with corresponding tap coefficients corresponding to the coding scheme of the ADC.

The DAC timing errors may include inter-symbol interference, ISI, and timing mismatch errors.

The integrator module and a multiplier between the correlation module and integrator module may provide the updated error coefficient by integration of the error term with an adjustable loop gain.

These and other aspects of the invention will be apparent from, and elucidated with reference to, the embodiments described hereinafter.

Brief description of Drawings

Embodiments will be described, by way of example only, with reference to the drawings, in which:

Figure 1 is a schematic diagram of an example ADC circuit comprising a delta-sigma modulator ADC;

Figure 2 is a schematic circuit diagram of an example differential resistive DAC element;

Figure 3 is a schematic plot of DAC current and error current for an example differential resistive DAC element operating an NRZ scheme;

Figure 4 is a schematic plot of DAC current and error current for an example differential resistive DAC element operating an RZ scheme;

Figure 5 is a schematic illustration of injection and correction of DAC timing errors in a model delta-sigma modulator ADC circuit;

Figure 6 is a plot of magnitude and phase of an example error transfer function for ISI and timing mismatch errors;

Figure 7 is a schematic diagram of an example calibration circuit for correcting timing errors;

Figures 8 and 9 are plots of converging error coefficients for a 3-bit NRZ DAC in a DSM ADC; and

Figure 10 is a plot of an example output spectrum before and after DAC error correction.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

Detailed description of embodiments

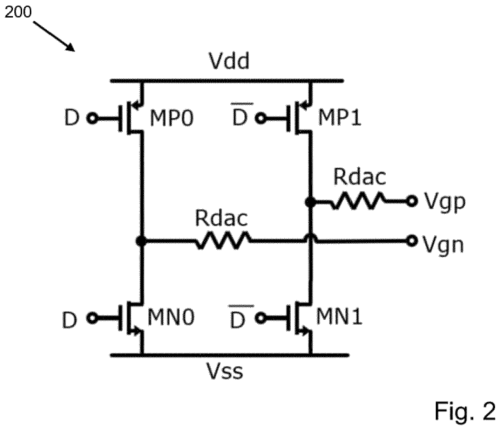

Figure 2 is a schematic circuit diagram illustrating a simple example of a differential resistive DAC element 200 that may be used in a DAC for an ADC circuit such as the ADC circuit described above with reference to Figure 1. The DAC element 200 consists of two resistors $R_{dac}$ and a set of switches $MP0$/$MN0$ and $MP1$/$MN1$. Signal inputs $D$ and $\overline{D}$ are outputs from the quantizer 103, which are then buffered to drive the DAC elements. Depending on the signs of $D$ and $\overline{D}$, the virtual ground $vgp$ and $vgn$ can either sink or source the DAC current into or from the loop filter 102. Any mismatch between the switches and resistors may cause both static mismatch errors and timing errors including ISI, and timing mismatch, creating non-linearity which degrades the performance of the DAC and the DSM. The scheme disclosed in US10541699B1 calibrates for static mismatch in the digital domain but does not address timing errors for calibrating ISI and timing mismatch errors.

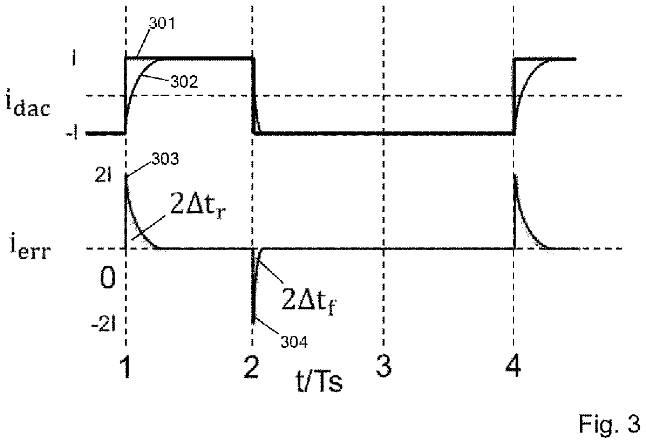

Figure 3 is an example plot illustrating the type of timing error that may be introduced by the resistive DAC element 200. A first trace 301 represents an ideal output current $i_{dac}$, while a second trace 302 represents an actual output current. In this example the DAC element is clocked at a clock period Ts and operates according to a non-return-to-zero (NRZ) scheme, in which the output current switches between a positive current I and a negative current -I. When the quantizer output signal $D$ is +1, the output current is +I, which sinks into the virtual ground vgp and sources from the virtual ground vgn When the quantizer output signal $D$ is -1, the output current of the DAC element is -I and flows in the opposite direction. Due to device mismatch and clock skew, the current trace 302 has finite and asymmetrical rise and fall times. The error current $i_{err}$ is an error waveform given by the difference between the ideal output current 301 and the actual output current 302. Time constants $\Delta t_r$ and $\Delta t_f$ are the time constants of the respective rising and falling curves 303, 304 of the error current waveforms. Time constants $\Delta t_r$ and $\Delta t_f$ may also include timing errors due to differences in switching moments between the differential pairs of switches MP0-MN0, MP1-MN1. If the quantizer output signal $D$ remains constant, the magnitude of the error waveform $i_{err}$ is zero. When the quantizer output signal $D$ transitions, either changing from a positive value to a negative value or vice versa, an error current is injected into the loop filter. This error current can be modelled as an exponentially decaying waveform with a peak value of 2I. In one clock period Ts, this error current builds up to an error charge. The absolute value of the error charge can be approximated when $\Delta t$ « $Ts$ as:

$$|Q_{err}| = \int_0^{Ts} 2I \cdot e^{-\frac{t}{\Delta t}} dt \approx 2\Delta t \cdot I$$

<div align="right">Equation 1</div>

where $\Delta t$ is $\Delta t_r$ when the data transition is positive ($\Delta D$ = +2) and $\Delta t_f$ when the data transition is negative ($\Delta D$ = -2). The error charge $Q_{err}$ is therefore data dependent, and is summarised in Table 1 below:

<div align="center">Table 1 - Data transitions and corresponding error charges</div>

| data transition ($\Delta D$) | error charge ($Q_{err}$) |
|:---:|:---:|
| +2 | $2\Delta t_r \cdot I$ |
| 0 | 0 |
| -2 | $-2\Delta t_f \cdot I$ |

From Table 1, the error charge $Q_{err}$ can be translated into a function of $\Delta D$:

$$Q_{err} = \frac{1}{4}(\Delta D + |\Delta D|) \cdot 2\Delta t_r \cdot I + \frac{1}{4}(\Delta D - |\Delta D|) \cdot 2\Delta t_f \cdot I$$

$$= |\Delta D|\frac{I}{2}(\Delta t_r - \Delta t_f) + \Delta D \frac{I}{2}(\Delta t_r + \Delta t_f)$$

<div align="right">Equation 2</div>

The ideal signal charge that should be injected in one clock period $T_s$ is $Q_{ideal}$ = I · $Ts$. The equivalent gain error sequence for an NRZ scheme can therefore be expressed as:

$$err_{NRZ} = \frac{Q_{err}}{Q_{ideal}} = |\Delta D| \frac{(\Delta t_r - \Delta t_f)}{2Ts} + \Delta D \frac{(\Delta t_r + \Delta t_f)}{2Ts}$$

$$= |\Delta D| e_{ISI} + \Delta D e_{MM_{NRZ}}$$

Equation 3

There are two terms in equation 3. The first term $|\Delta D| e_{ISI}$ represents the ISI, where $e_{ISI} = \frac{\Delta t_r - \Delta t_f}{2Ts}$ is the error coefficient of each DAC element, which creates non-linearity due to asymmetries between the time constants of the respective rising and falling sections $\Delta t_r$, $\Delta t_f$ of the error waveform $i_{err}$ (i.e. when $\Delta t_r \neq \Delta t_f$). The second term $\Delta D e_{MM_{NRZ}}$ is correlated to the signal, where $e_{MM_{NRZ}} = \frac{\Delta t_r + \Delta t_f}{2Ts}$ is the error coefficient of each DAC element, which causes non-linearity in multi-bit DACs.

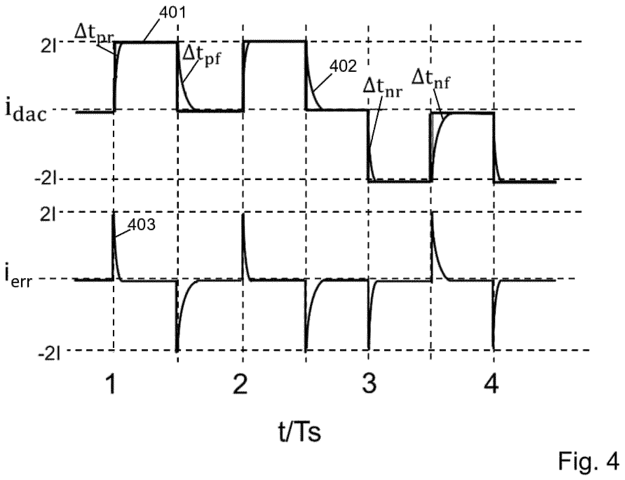

To reduce or eliminate ISI, return-to-zero (RZ) and dual-return-to-zero (DRZ) architectures may be used, which can solve the problem in the case of single-bit DACs. However, timing mismatches remain and cause non-linearity in the case of multi-bit DACs. Figure 4 illustrates example timing errors in a RZ scheme operating with a clock period Ts. As with Figure 3, a first trace 401 represents an ideal output DAC current $i_{dac}$ and a second trace 402 represents an actual output current. An error waveform $i_{err}$ 403 represents the difference between the ideal output current 401 and the actual output current 402. Errors are injected twice per clock cycle for the RZ scheme at t and t + 0.5Ts. The equivalent gain error sequence for an RZ scheme can be expressed as:

$$err_{RZ} = \frac{Q_{err}}{Q_{ideal}}$$

$$= \frac{1}{0.5Ts \cdot 2I} \left\{ \frac{1}{2} \left[ (D+1)\Delta t_{pr} + z^{-0.5}(D+1)(-\Delta t_{pf}) \right] \cdot 2I \right.$$

$$\left. + \frac{1}{2} \left[ (D-1)\Delta t_{nr} + z^{-0.5}(D-1)(-\Delta t_{nf}) \right] \cdot 2I \right\}$$

$$= D \frac{(\Delta t_{pr} + \Delta t_{nr})}{Ts} + z^{-0.5} D \frac{-(\Delta t_{pf} + \Delta t_{nf})}{Ts} + DC$$

$$= D e_{MM_{RZ1}} + z^{-0.5} D e_{MM_{RZ2}} + DC$$

Equation 4

where $\Delta t_{pr}$ and $\Delta t_{pf}$ are the time constants of the respective rising and falling sections of the error waveform $i_{err}$ when the quantizer output signal $D$ is +1 and $\Delta t_{nr}$ and $\Delta t_{nf}$ are the time constants of the respective rising and falling sections of the error waveform $i_{err}$ when the quantizer output signal $D$ is -1.

The first two terms in equation 4 are correlated to the quantizer output signal $D$. The timing mismatch error coefficients $e_{MM_{RZ1}}$ and $e_{MM_{RZ2}}$ for each DAC element result in non-linearity in multi-bit cases. The third term is a DC offset that does not impact the linearity of the DAC.

In a DRZ switching scheme, an error current is injected three times in every clock period $T_s$, i.e. at t, t + 0.5Ts and t + $T_s$. The equivalent gain error sequence for a DAC operating a DRZ switching scheme can be expressed as:

$$err_{DRZ} = D e_{MM_{DRZ1}} + z^{-0.5} D e_{MM_{DRZ2}} + z^{-1} D e_{MM_{DRZ3}} + DC$$

Equation 5

where $e_{MM_{RZ1}}$, $e_{MM_{RZ2}}$ and $e_{MM_{RZ3}}$ are the timing mismatch error coefficients for a DRZ DAC element.

Equations 3 to 5 above illustrate that the timing errors, i.e. ISI and timing mismatch, are all correlated to the quantizer output signal $D$ in the form $|\Delta D|$, $\Delta D$, $D$, $z^{-0.5}D$ or $z^{-1}D$. With the error transfer function (ETF) of the system, it is therefore possible to estimate how the data-correlated errors are propagated from the DAC to the output. It is then possible to correct for these errors at the output without modifying the system.

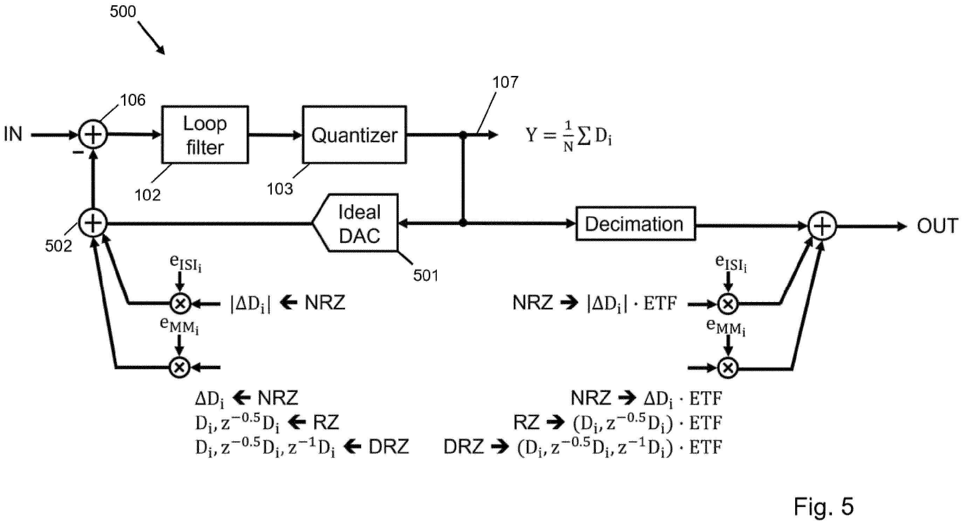

Figure 5 is a schematic illustration of a model ADC circuit 500, in which the timing errors introduced by a real DAC are shown as additions to an ideal N-element DAC 501 and added with the summing module 502. The ADC part of the circuit 500 is otherwise similar to the DSM of Figure 1, i.e. comprising a loop filter 102, an N-element quantizer 103 and input summing module 106. The quantizer output 107 is a series of vectors $D_i$, where $i$ = 1:$N$ (N being the number of elements in the quantizer 103), and Y is the equivalent analog output of the modulator. Similar models are possible for other ADC configurations such as a CT pipeline ADC or a CT zoom ADC.

The timing error sequences added to the output of the ideal DAC 501 differ according to the switching scheme. In the example of an NRZ switching scheme, the timing error sequence contains an ISI term $|\Delta D|e_{ISI}$ and a timing mismatch term $\Delta De_{MM_{NRZ}}$. With an RZ switching scheme, the timing mismatch error sequences are $De_{MM_{RZ1}}$ and $z^{-0.5}De_{MM_{RZ2}}$. With a DRZ switching scheme, the timing error sequence contains three terms $De_{MM_{DRZ1}}$, $z^{-0.5}De_{MM_{DRZ2}}$ and $z^{-1}De_{MM_{DRZ3}}$. Taking the example of an NRZ scheme, the ADC output $Y$ may be expressed as:

$$\mathrm{Y} = STF \cdot IN + NTF \cdot E_Q - ETF \cdot \sum |\Delta D_i| \cdot e_{ISI_i} - ETF \cdot \sum \Delta D_i \cdot e_{MM_{i_{NRZ}}}$$

Equation 6

where $STF$ and $NTF$ are the respective input signal and quantization noise transfer functions, $IN$ is the analog input signal and $E_Q$ is the quantization error.

The error transfer function from the DAC to the output is determined by the loop transfer function and the error waveform. From Equation 6 above, if the error coefficients can be determined, the errors can be compensated by adding the estimated filtered error sequences on top of the output Y, so that the output signal OUT is free of DAC errors and only contains the wanted signal and the shaped quantization error. Convergence of coefficients can be performed digitally, while correction can be done in analog or in digital or a combination of both.

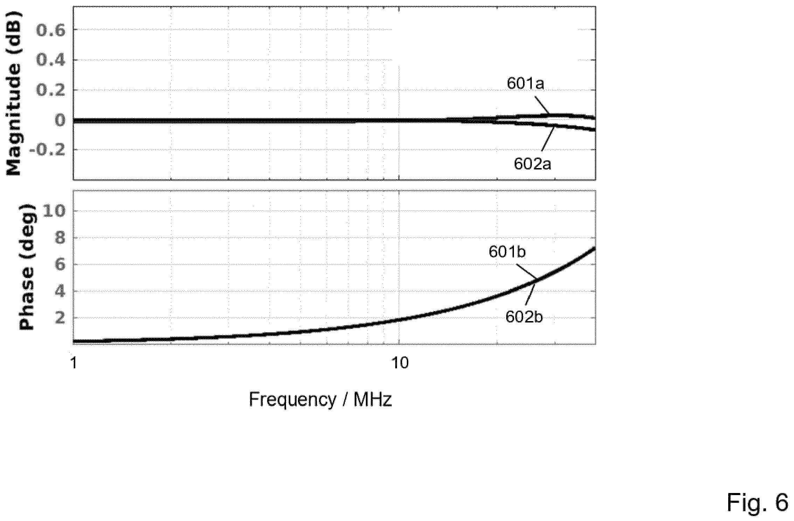

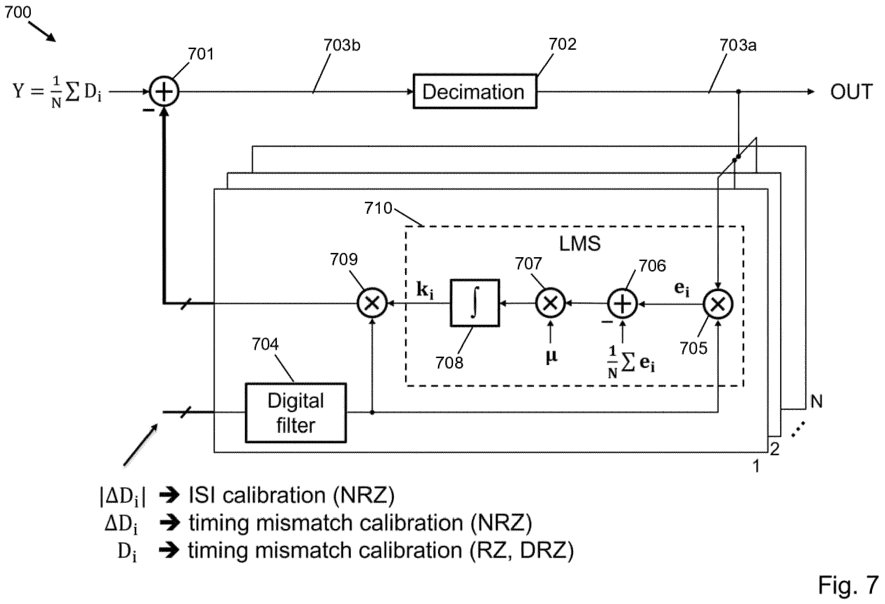

Based on the model in Figure 5, when both the ETF and error coefficients are known the errors can be compensated at the output. Figure 7, described in further detail below, illustrates how these error coefficients can be estimated for each element using least-mean square (LMS). The timing errors present in the ADC output Y are correlated to the data and filtered by the ETF. In the case of an NRZ scheme, ISI errors are correlated to $|\Delta D_i|$ and timing mismatch errors are correlated to $\Delta D_i$. In RZ and DRZ schemes, timing mismatch errors are correlated to $D_i$. The ETFs are different with different waveforms and coding schemes and can be implemented using differently configured finite impulse response (FIR) filters to approximate the ETF in each case. The number of taps of an FIR filter can be chosen and the tap coefficients can be calculated or calibrated together with the DAC errors. For an NRZ scheme, both ISI and timing mismatch errors have the same ETF, an example of which is shown in Figure 6, which illustrates an ideal response 601 and an approximation response 602 as a function of frequency. In this case, a 2-tap FIR filter 704 is used to approximate the error transfer function for the NRZ timing error, with a phase lead. The magnitude responses have less than 0.2dB difference between the ideal 601a and approximation 602a. The phase response is almost identical for the ideal 601b and approximation 602b. With a simple 2-tap FIR filter, the ETF can be approximated sufficiently accurately over the modulator bandwidth, which in this case ranges up to 40 MHz.

The calibration circuit 700 illustrated in Figure 7 comprises an input subtraction module 701 that is configured to subtract an estimated error from the equivalent analog output Y 107 of an ADC and provide a corrected output. The calibration circuit 700 may implement a digital calibration module 108 for an ADC circuit 100 with a continuous time delta-sigma modulator, as in Figure 1, in which the calibration circuit corrects for timing errors in the ADC output introduced by the DAC 104. The calibration circuit 700 may alternatively be used to correct for DAC timing errors in other types of ADCs such as in a continuous time pipeline ADC or a continuous time zoom ADC.

The corrected output OUT used for correlation can either be prior or after the decimation filter 702 (i.e. either outputs 703a or 703b).

The LMS method of estimating error coefficients for each element is represented by an LMS module 710, which comprises a correlation module 705, a multiplier 707 having an adjustable loop gain and an integrator 708. The subtraction module 706 is optional.

The correction and coefficients searching can be done on the decimated signal as well.

In the example in Figure 7, the corrected output from the input subtraction module 701 is provided to the correlation module 705, which correlates the corrected output with an output from the digital filter module 704 to extract an error term $e_i$ for one DAC element. The error term $e_i$ is then provided to the multiplier 707 and integrator 708.

In the case of a multi-bit ADC, i.e. where N>1, an optional subtraction block 706 may subtract the mean of all error terms (the common error) from each error term $e_i$ before the error term is provided to the multiplier 707. The multiplier 707 multiplies the error term with an adjustable loop gain $\mu$. The output of multiplier 707 is integrated by the integrator module 708, which provides an updated error coefficient $\boldsymbol{k_i}$. The loop gain $\mu$ of the multiplier 707 is designed to control the convergence speed of the calibration.

The updated error coefficient $\boldsymbol{k_i}$ is provided to the correction module 709, which multiplies the updated error coefficient $\boldsymbol{k_i}$ with the output from the filter module 704 to provide the estimated error to the input subtraction module 701. After multiple rounds of operations of the calibration circuit 700, the (average of) the error term $e_i$ should eventually converge to zero, which results in a stable error coefficient $k_i$.

Operation of the calibration scheme implemented by the circuit 700 illustrated in Figure 7 may be illustrated by taking the correction of an ISI error as an example. The digital filter 704 implements a filter function $H_{FIR}$ which imitates the ETF. The error coefficients $k_i$ ($i = 1{:}N$) are the correction coefficients which estimate the error coefficient of each DAC element so that $k_i|\Delta D_i|H_{FIR}$ is the estimated ISI error to be corrected in Y. $k_i|\Delta D_i|H_{FIR}$ is subtracted from the ADC output Y and is correlated with $|\Delta D_i|H_{FIR}$ to extract the error term $e_i$ of each element. The error coefficient $k_i$ is then updated with the integration of $e_i$ with an adjustable loop gain $\mu$. The common error between each element does not have impact on the linearity and can be subtracted from $e_i$ to speed up the convergence, which is illustrated in Figure 7 as an optional subtraction block 706. Once the error coefficient $k_i$ starts to converge, it becomes closer to the real error coefficient, resulting in a smaller correlation value between $|\Delta D_i|H_{FIR}$ and ($Y - k_i|\Delta D_i|H_{FIR}$), and thereby making (the average of) $e_i$ gradually reduce to zero, and $k_i$ a stable value.

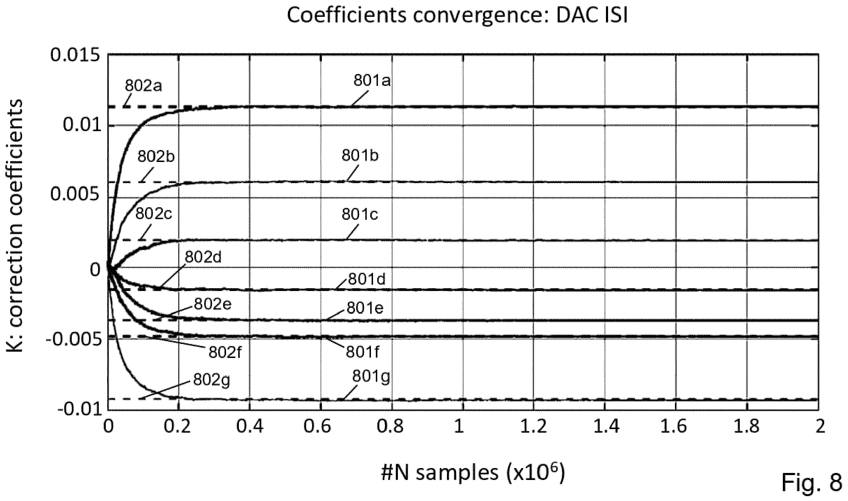

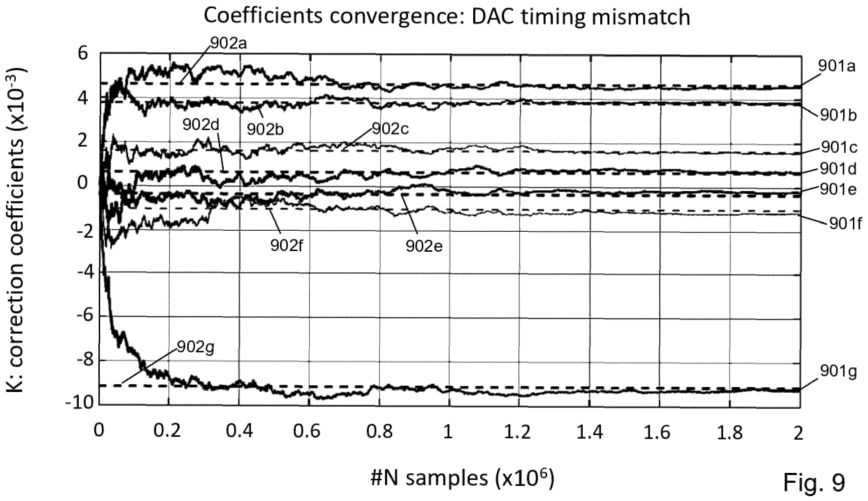

Figures 8 and 9 are example plots illustrating convergence of error coefficients $k_i$ for a 3-bit (7 elements), NRZ DAC in a DSM, where ISI and timing mismatch errors are present, Figure 8 showing coefficients converging for ISI and Figure 9 for coefficients converging for timing mismatch errors. Static mismatch errors can be covered by a suitable calibration circuit as described in US10541699B1 and will therefore not be addressed here. The dashed lines 802a-g in Figure 8 and 902a-g in Figure 9 correspond to ideal error coefficients from calculation, while the solid lines 801a-g and 901a-g represent the correction coefficients $k_i$ ($i = 1{:}7$). The coefficients all initially start at zero and then, eventually converge to the ideal error coefficients, in this case within around 600,000 samples.

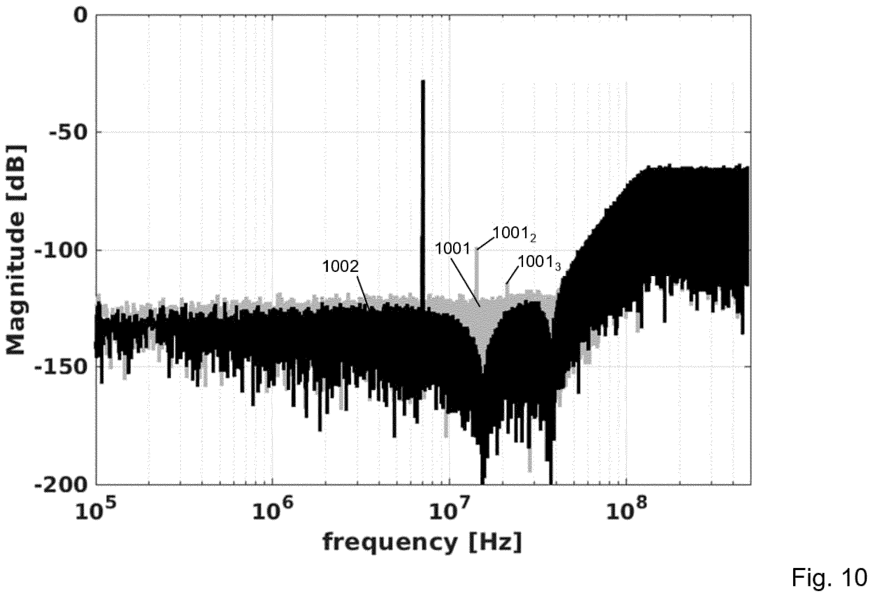

Figure 10 is an example plot illustrating an output spectrum before and after DAC error correction. In the original output 1001, the 2nd and 3rd harmonics $1001_2$, $1001_3$ are clearly visible when ISI and timing mismatch errors are present. The noise floor is also higher as the non-linear DAC mixes with the quantization error. After timing error correction, the corrected spectrum 1002 is close to ideal.

The calibration scheme described herein also works well when static mismatch errors are present and can be combined with schemes such as those in US10541699B1 to cover both static and dynamic DAC errors. The scheme is straightforward to implement digitally, and with no specific test signals required. The scheme can also be generalized to other types of DACs with different architectures such as resistive or current-steering architectures, other coding schemes such as unary, binary or segmented coding schemes, and to different switching schemes (NRZ, RZ, DRZ, as described above). When the error mechanism is known, the calibration scheme can be used at the system output to estimate and correct the errors without affecting normal operation of the ADC.

From reading the present disclosure, other variations and modifications will be apparent to the skilled person. Such variations and modifications may involve equivalent and other features which are already known in the art of DAC calibration schemes, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other element may fulfil the functions of several means recited in the claims and reference signs in the claims shall not be construed as limiting the scope of the claims.

## Claims

1. A calibration circuit (700) for correcting timing errors introduced by a DAC (104) in a signal path of an ADC (101), the calibration circuit (700) comprising:

   an input subtraction module (701) configured to subtract an estimated error from an output of the ADC (101) and provide a corrected output (703a, 703b);
a filter module (704) configured to approximate an error transfer function corresponding to the DAC timing errors;
a correlation module (705) configured to correlate the corrected output (703a, 703b) with an output from the filter module (704) to extract an error term ($e_i$);
an integrator module (708) configured to integrate the error term ($e_i$) to provide an updated error coefficient ($k_i$); and
a correction module (709) configured to multiply the updated error coefficient ($k_i$) with the output from the filter module (704) to provide the estimated error to the input subtraction module (701).

2. The calibration circuit (700) of claim 1, wherein the filter module (704) comprises a finite impulse response, FIR, or an infinite impulse response, IIR, filter.

3. The calibration circuit (700) of claim 1 or claim 2, wherein the error transfer function corresponds to a coding scheme of the ADC, the coding scheme being one of a return to zero scheme, a non-return to zero scheme, and a dual return to zero scheme.

4. The calibration circuit (700) of claim 3, wherein the filter module (704) comprises a plurality of taps with corresponding tap coefficients corresponding to the coding scheme of the ADC.

5. The calibration circuit (700) of any preceding claim, wherein the DAC timing errors include inter-symbol interference, ISI, and timing mismatch errors.

6. The calibration circuit (700) of any preceding claim, comprising a multiplier (707) between the correlation module (705) and integrator module (708), the multiplier and integrator module (707, 708) configured to provide the updated error coefficient by integration of the error term with an adjustable loop gain.

7. An ADC circuit comprising:

an ADC having an input for receiving an analog input signal, an output for providing a digital signal and a signal path between the input and output comprising a DAC; and
a calibration circuit according to any preceding claim connected to the output of the ADC.

8. The ADC circuit of claim 7, wherein the ADC is selected from one of:

a continuous time delta-sigma modulator;
a continuous time pipeline ADC; and
a continuous time zoom ADC.

9. The ADC circuit of claim 7 or claim 8, wherein the DAC is a single-bit or multi-bit DAC having N elements, the ADC circuit having N calibration circuits corresponding to each of the N elements of the DAC.

10. A method of correcting timing errors introduced by a DAC (104) in a signal path of an ADC (101) with a calibration circuit (700), the method comprising:

subtracting with an input subtraction module (701) an estimated error from an output of the ADC (101) and providing a corrected output (703a, 703b);
approximating with a filter module (704) an error transfer function corresponding to the DAC timing errors;
correlating with a correlation module (705) the corrected output (703a, 703b) with an output from the filter module (704) to extract an error term ($e_i$);
integrating with an integrator module (708) the error term ($e_i$) to provide an updated error coefficient ($k_i$); and
multiplying with a correction module (709) the updated error coefficient ($k_i$) with the output from the filter module (704) to provide the estimated error to the input subtraction module (701).

11. The method of claim 10, wherein the filter module (704) comprises a finite impulse response, FIR, or an infinite impulse response, IIR, filter.

12. The method of claim 10 or claim 11, wherein the error transfer function corresponds to a coding scheme of the ADC, the coding scheme being one of a return to zero scheme, a non-return to zero scheme, and a dual return to zero scheme.

13. The method of claim 12, wherein the filter module (704) comprises a plurality of taps with corresponding tap coefficients corresponding to the coding scheme of the ADC.

14. The method of any one of claims 10 to 13, wherein the DAC timing errors include inter-symbol interference, ISI, and timing mismatch errors.

15. The method of any one of claims 10 to 14, wherein the integrator module (708) and a multiplier (707) between the correlation module (705) and integrator module (708) provide the updated error coefficient by integration of the error term with an adjustable loop gain.

**Amended claims in accordance with Rule 137(2) EPC.**

1. An ADC circuit comprising:

   an ADC (101) having an input for receiving an analog input signal, an output for providing a digital signal and a signal path between the input and output comprising a DAC (104) having N elements; and
   N calibration circuits (700) corresponding to each of the N elements of the DAC (104), each calibration circuit (700) for correcting timing errors introduced by the DAC (104) in a signal path of an ADC (101), each calibration circuit (700) comprising:

      an input subtraction module (701) connected to the output of the ADC (101) and configured to subtract an estimated error from the output of the ADC (101) and provide a corrected output (703a, 703b);
      a filter module (704) configured to approximate an error transfer function corresponding to the DAC timing errors from an input timing error sequence;
      a correlation module (705) configured to correlate the corrected output (703a, 703b) with an output from the filter module (704) to extract an error term ($e_i$);
      an integrator module (708) configured to integrate the error term ($e_i$) to provide an updated error coefficient ($k_i$); and
      a correction module (709) configured to multiply the updated error coefficient ($k_i$) with the output from the filter module (704) to provide the estimated error to the input subtraction module (701).

2. The calibration circuit (700) of claim 1, wherein the filter module (704) comprises a finite impulse response, FIR, or an infinite impulse response, IIR, filter.

3. The calibration circuit (700) of claim 1 or claim 2, wherein the error transfer function corresponds to a coding scheme of the ADC, the coding scheme being one of a return to zero scheme, a non-return to zero scheme, and a dual return to zero scheme.

4. The calibration circuit (700) of claim 3, wherein the filter module (704) comprises a plurality of taps with corresponding tap coefficients corresponding to the coding scheme of the ADC.

5. The calibration circuit (700) of any preceding claim, wherein the DAC timing errors include inter-symbol interference, ISI, and timing mismatch errors.

6. The calibration circuit (700) of any preceding claim, comprising a multiplier (707) between the correlation module (705) and integrator module (708), the multiplier and integrator module (707, 708) configured to provide the updated error coefficient by integration of the error term with an adjustable loop gain.

7. The ADC circuit of claim 1, wherein the ADC (101) is selected from one of:

   a continuous time delta-sigma modulator;
   a continuous time pipeline ADC; and
   a continuous time zoom ADC.

8. A method of correcting timing errors introduced by a DAC (104) in a signal path of an ADC (101) with N calibration circuits (700), the ADC (101) having an input for receiving an analog input signal, an output for providing a digital signal and a signal path between the input and output comprising a DAC (104) having N elements the method comprising for each calibration circuit (700):

subtracting with an input subtraction module (701) an estimated error from an output of the ADC (101) and providing a corrected output (703a, 703b);

approximating with a filter module (704) an error transfer function corresponding to the DAC timing errors from an input timing error sequence;

correlating with a correlation module (705) the corrected output (703a, 703b) with an output from the filter module (704) to extract an error term ($e_i$);

integrating with an integrator module (708) the error term ($e_i$) to provide an updated error coefficient ($k_i$); and

multiplying with a correction module (709) the updated error coefficient ($k_i$) with the output from the filter module (704) to provide the estimated error to the input subtraction module (701).

9. The method of claim 8, wherein the filter module (704) comprises a finite impulse response, FIR**,** or an infinite impulse response, IIR, filter.

10. The method of claim 8 or claim 9, wherein the error transfer function corresponds to a coding scheme of the ADC, the coding scheme being one of a return to zero scheme, a non-return to zero scheme, and a dual return to zero scheme.

11. The method of claim 10, wherein the filter module (704) comprises a plurality of taps with corresponding tap coefficients corresponding to the coding scheme of the ADC.

12. The method of any one of claims 8 to 11, wherein the DAC timing errors include inter-symbol interference, ISI, and timing mismatch errors.

13. The method of any one of claims 8 to 12, wherein the integrator module (708) and a multiplier (707) between the correlation module (705) and integrator module (708) provide the updated error coefficient by integration of the error term with an adjustable loop gain.

Fig. 1

EP 4 637 036 A1

Fig. 2

Fig. 3

EP 4 637 036 A1

Fig. 4

Fig. 5

Fig. 6

EP 4 637 036 A1

$Y = \frac{1}{N}\sum D_i$

Decimation

OUT

LMS

$k_i$

$\mu$

$\frac{1}{N}\sum e_i$

$e_i$

Digital filter

$|\Delta D_i|$ → ISI calibration (NRZ)
$\Delta D_i$ → timing mismatch calibration (NRZ)
$D_i$ → timing mismatch calibration (RZ, DRZ)

Fig. 7

EP 4 637 036 A1

Coefficients convergence: DAC ISI

Fig. 8

EP 4 637 036 A1

Coefficients convergence: DAC timing mismatch

Fig. 9

EP 4 637 036 A1

Fig. 10

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHAO CHENGXUAN ET AL: "Correlation-based reconfigurable blind calibration for timing mismatches in TI-ADCs", ANALOG INTEGRATED CIRCUITS AND SIGNAL PROCESSING, vol. 107, no. 1, 7 January 2021 (2021-01-07), pages 29-38, XP037409209, ISSN: 0925-1030, DOI: 10.1007/S10470-020-01788-6 * pages 30-31; figures 2,3 * | 1-15 | INV. H03M1/10 H03M3/00 ADD. H03M1/14 H03M1/38 |
| A | US 7 894 536 B2 (TEXAS INSTRUMENTS INC [US]) 22 February 2011 (2011-02-22) * paragraph [0075]; figure 15 * | 1-15 | |
| A | DRIEMEYER BJOERN ET AL: "PUF-Entropy Extraction of DAC Intersymbol-Interference using Continuous-Time Delta-Sigma ADCs", 2022 29TH IEEE INTERNATIONAL CONFERENCE ON ELECTRONICS, CIRCUITS AND SYSTEMS (ICECS), IEEE, 24 October 2022 (2022-10-24), pages 1-4, XP034245386, DOI: 10.1109/ICECS202256217.2022.9971072 [retrieved on 2022-12-12] * Abstract; page 2 * | 1-15 | TECHNICAL FIELDS SEARCHED (IPC) H03M |

-/--

The present search report has been drawn up for all claims

| Place of search | Date of completion of the search | Examiner |
|---|---|---|
| The Hague | 10 October 2024 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 17 1246

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | X WANG ET AL: "DIGITAL CORRELATION TECHNIQUE FOR THE ESTIMATION AND CORRECTION OF DAC ERRORS IN MULTIBIT MASH DELTA-SIGMA ADCs", PROCEEDINGS / 2002 IEEE INTERNATIONAL SYMPOSIUM ON CIRCUITS AND SYSTEMS : MAY 26 - 29, 2002, FAIRMONT SCOTTSDALE PRINCESS, PHOENIX-SCOTTSDALE, ARIZONA, U.S.A., vol. IV, 29 May 2002 (2002-05-29), pages 691-694, XP055368655, Piscataway, NJ, US DOI: 10.1109/ISCAS.2002.1010550 ISBN: 978-0-7803-7448-5 * figure 1 * | 1-15 | |

-----

TECHNICAL FIELDS
SEARCHED (IPC)

The present search report has been drawn up for all claims

| Place of search | Date of completion of the search | Examiner |
|---|---|---|
| The Hague | 10 October 2024 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 ..........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 1246

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2024

| Patent document cited in search report | Publication date | Patent family member(s) | Publication date |
|---|---|---|---|
| US 7894536 B2 | 22-02-2011 | NONE | |

For more details about this annex : see Official Journal of the European Patent Office, No. 12/82

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10541699 B1